# EUROPEAN PATENT APPLICATION

(11) **EP 4 583 153 A1**
(43) Date of publication of application: **09.07.2025**
(21) Application number: 23936254.4
(22) Date of filing: 27.06.2023
(51) Int. Cl.: H01L 21/67, H01L 21/687, H01L 21/683

(54) **WAFER SEPARATION APPARATUS AND WAFER SEPARATION METHOD**

(30) Priority: 10.05.2023 CN 202310519917
(71) Applicant: Shangai Advanced Silicon Technology Co., Ltd, Shanghai 201616 (CN); Chongquing Advanced Silicon Technology Co., Ltd., Chongqing 400714 (CN)
(72) Inventor: PENG, Haijing, Shanghai 201616 (CN); ZHANG, Dapeng, Shanghai 201616 (CN); CHEN, Meng, Shanghai 201616 (CN)
(74) Representative: Mitola, Marco
(86) International application number: PCT/CN2023/102579
(87) International publication number: WO 2024/229945

(57) **Abstract**

Provided are a wafer splitting system and a wafer splitting method, which belong to the field of semiconductor equipment technology. The wafer splitting system includes a mounting frame, a carrier assembly, a separation assembly, a clamping assembly, and a drive assembly. When the separation assembly blows a bonded wafer, a high-pressure airflow flows through two sides of the bonded wafer, air pressure on the two sides of the bonded wafer decreases, and two wafers of the bonded wafer are each subjected to an outward force according to Bernoulli's principle so that the bonded wafer is separated into a donor wafer and an SOI wafer.

## Description

This application claims priority to Chinese Patent Application No. 202310519917.1 filed with the China National Intellectual Property Administration (CNIPA) on May 10, 2023, the disclosure of which is incorporated herein by reference in its entirety.

### TECHNICAL FIELD

The present application relates to the field of semiconductor equipment technology, for example, a wafer splitting system and a wafer splitting method.

### BACKGROUND

Silicon on insulator (SOI) technology is to form an oxide layer between a Si layer and a Si wafer through a special oxidation reaction of the Si wafer to ultimately form the structure of a thin layer of silicon/insulating layer of silicon dioxide/silicon substrate. SOI semiconductors have the characteristics of high radiation resistance, high speed, high heat dissipation capability, and low production cost.

Currently, a bonded wafer produced by using the SOI technology is mainly separated by a mechanical separation method into a donor wafer (where the donor wafer in the present application refers to a silicon substrate structure, that is, a silicon substrate wafer) and an SOI wafer. The mechanical contact and separation of wafers easily cause damage to an edge of a wafer, cause particle contamination, affect a product yield, and increase a production cost. Moreover, a separation machine is relatively complex in structure, required to be debugged with a high requirement, and maintained with a relatively large difficulty.

Therefore, a wafer splitting system and a wafer splitting method are urgently needed to solve the preceding problems.

### SUMMARY

The present application provides a wafer splitting system configured to separate a bonded wafer into a donor wafer and an SOI wafer.

In a first aspect, the present application provides a wafer splitting system configured to separate a bonded wafer. The wafer splitting system includes a mounting frame, a carrier assembly, a separation assembly, a clamping assembly, and a drive assembly.

The carrier assembly includes a support comb frame, where the support comb frame is provided with multiple parallel slots which are vertically arranged, a slot of the multiple parallel slots is capable of storing the bonded wafer to be separated, and the carrier assembly is mounted to the mounting frame.

The separation assembly includes an air knife and an air pipe, where one end of the air pipe is connected to the air knife, the other end of the air pipe is connected to an air source, the air knife is configured to separate the bonded wafer, and the bonded wafer is separable into a donor wafer and an SOI wafer.

The clamping assembly includes a first fixture and a second fixture, where the first fixture can clamp or release the donor wafer, and the second fixture can clamp or release the donor wafer and the SOI wafer.

The drive assembly is mounted to the mounting frame, the drive assembly is configured to drive the clamping assembly to clamp or release the donor wafer and the SOI wafer, and the drive assembly is further configured to drive the carrier assembly to move the bonded wafer to an air outlet of the air knife.

The present application further provides a wafer splitting method for separating a bonded wafer into a donor wafer and an SOI wafer.

In a second aspect, the wafer splitting method includes S1 and S2.

In S1, a to-be-separated bonded wafer is placed on a support comb frame, and a drive assembly drives a carrier assembly to move the bonded wafer to an air outlet of an air knife.

In S2, high-pressure air is controlled to be delivered through an air pipe to the air outlet of the air knife and ejected, where a high-pressure airflow flows through two sides of the bonded wafer, air pressure on the two sides of the bonded wafer decreases, and the two sides of the bonded wafer are subjected to outward forces according to Bernoulli's principle so that the bonded wafer is separated into a donor wafer and an SOI wafer.

As an exemplary technical solution of the wafer splitting method, a wafer splitting system includes a first cartridge, and the wafer splitting method further includes S3 and S4.

In S3, the drive assembly drives a first fixture to clamp the donor wafer, and the drive assembly drives a second fixture to simultaneously lift the donor wafer and the SOI wafer.

In S4, the donor wafer and the SOI wafer being simultaneously clamped by the first fixture and the second fixture are moved over the first cartridge, the drive assembly controls the first cartridge to move upward and approach the SOI wafer, and the second fixture releases the donor wafer and the SOI wafer so that the SOI wafer falls into the first cartridge with the donor wafer clamped by the first fixture.

### BRIEF DESCRIPTION OF DRAWINGS

FIG. 1 is a structural view of a wafer splitting system according to embodiment one of the present application.
FIG. 2 is a structural view of a clamping comb frame according to embodiment one of the present application.
FIG. 3 is a structural view of a lifting comb frame according to embodiment one of the present application.
FIG. 4 is a flowchart of a wafer splitting method according to embodiment one of the present application.
FIG. 5 is a flowchart of a wafer splitting method according to embodiment two of the present application.

### Reference list:

- 1: carrier assembly
- 11: support comb frame
- 12: quartz boat
- 2: separation assembly
- 21: air knife
- 22: air pipe
- 23: switch valve
- 24: airflow adjustment valve
- 3: clamping assembly
- 31: first fixture
- 311: clamping comb frame
- 3111: avoidance slot
- 3112: clamping slot
- 32: second fixture
- 321: lifting comb frame
- 3211: lifting slot
- 4: first cartridge
- 5: second cartridge

### DETAILED DESCRIPTION

The present application is described in detail below in conjunction with drawings and embodiments.

In the description of the present application, terms "joined", "connected", and "fixed" are to be understood in a broad sense unless otherwise expressly specified and limited. For example, the term "connected" may refer to "fixedly connected", "detachably connected", or "integrated", may refer to "mechanically connected" or "electrically connected", or may refer to "connected directly", "connected indirectly through an intermediary", or "connected inside two components" or an interaction relation between two components. For those of ordinary skill in the art, specific meanings of the preceding terms in the present application may be understood based on specific situations.

In the present application, unless otherwise expressly specified and limited, when a first feature is described as "on" or "under" a second feature, the first feature and the second feature may be in direct contact or may be in indirect contact via another feature between the two features instead of being in direct contact. Moreover, when the first feature is described as "on", "above", or "over" the second feature, the first feature is right on, above, or over the second feature, the first feature is obliquely on, above, or over the second feature, or the first feature is simply at a higher level than the second feature. When the first feature is described as "under", "below", or "underneath" the second feature, the first feature is right under, below, or underneath the second feature, the first feature is obliquely under, below, or underneath the second feature, or the first feature is simply at a lower level than the second feature.

In the description of embodiments, orientations or position relations indicated by terms such as "upper", "lower", and "right" are based on the drawings. These orientations or position relations are intended only to facilitate description and simplify operation and not to indicate or imply that a device or element referred to must have such particular orientations or must be configured or operated in such particular orientations. Thus, these orientations or position relations are not to be construed as limiting the present application. Moreover, terms "first" and "second" are used only for distinguishing description and have no special meanings.

### Embodiment one

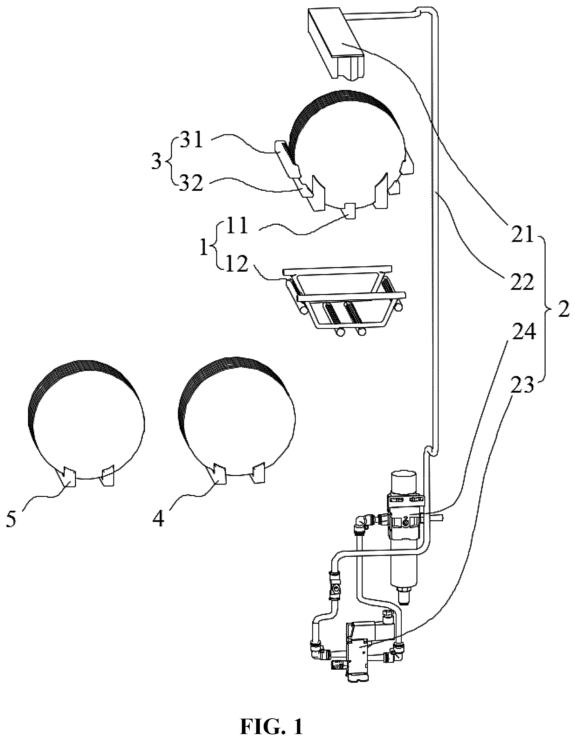

As shown in FIGS. 1 to 3, this embodiment provides a wafer splitting system configured to separate a bonded wafer, and the wafer splitting system includes a mounting frame, a carrier assembly 1, a separation assembly 2, a clamping assembly 3, and a drive assembly; the carrier assembly 1 includes a support comb frame 11, the support comb frame 11 is provided with multiple parallel slots which are vertically arranged, a slot is capable of storing the bonded wafer to be separated, and the carrier assembly 1 is mounted to the mounting frame; the separation assembly 2 includes an air knife 21 and an air pipe 22, one end of the air pipe 22 is connected to the air knife 21, the other end of the air pipe 22 is connected to an air source, the air knife 21 is configured to separate the bonded wafer, and the bonded wafer is separable into a donor wafer (where the donor wafer in the present application refers to a silicon substrate structure, that is, a silicon substrate wafer) and an SOI wafer; the clamping assembly includes a first fixture 31 and a second fixture 32, the first fixture 31 is capable of clamping or releasing the donor wafer, and the second fixture 32 is capable of clamping or releasing the donor wafer and the SOI wafer; the drive assembly is mounted to the mounting frame, the drive assembly is configured to drive the clamping assembly 3 to clamp or release the donor wafer and the SOI wafer, and the drive assembly is further configured to drive the carrier assembly 1 to move the bonded wafer to an air outlet of the air knife 21. For example, the carrier assembly 1 further includes a quartz boat 12, and the drive assembly drives the support comb frame 11 to move to drive the bonded wafer to approach the air outlet of the air knife 21. The width of the slot of the support comb frame 11 is greater than the thickness of the bonded wafer so that the bonded wafer is easy to separate. When the air knife 21 blows the bonded wafer, a high-pressure airflow flows through two sides of the bonded wafer, air pressure on the two sides of the bonded wafer decreases, and two wafers of the bonded wafer are each subjected to an outward force according to Bernoulli's principle so that the bonded wafer is separated into the donor wafer and the SOI wafer, thereby achieving a relatively good separation effect and avoiding damage due to mechanical clamping and separation. Multiple bonded wafers can be simultaneously separated, thereby effectively improving operation efficiency. The clamping assembly 3 is manipulated to selectively clamp, convey, or release the donor wafer and the SOI wafer so that the donor wafer and the SOI wafer can be separated and collected. The wafer splitting system provided in this embodiment separates the donor wafer and the SOI wafer from each other under the action of atmospheric pressure according to Bernoulli's principle, thereby avoiding damage caused by mechanical clamping to a product. Multiple bonded wafers can be simultaneously separated, thereby improving the operation efficiency. After the to-be-separated bonded wafer is placed on the carrier assembly, the drive assembly drives the carrier assembly to move the bonded wafer to the air outlet of the air knife. According to Bernoulli's principle, a high-speed airflow is ejected from the air knife to the outer sides of the bonded wafer, the pressure on the two sides of the bonded wafer decreases, and the donor wafer and the SOI wafer are separated from each other under the action of atmospheric pressure, thereby avoiding damage caused by the mechanical clamping to the product. Multiple bonded wafers can be simultaneously separated, thereby improving the operation efficiency.

The separation assembly 2 in this embodiment further includes a switch valve 23 and an airflow adjustment valve 24, the switch valve 23 is mounted on the air pipe 22 and configured to control the air source to be connected or disconnected, and the airflow adjustment valve 24 is configured to adjust a magnitude of airflow in the air pipe 22 to adjust an air outflow of the air knife 21, thereby achieving a better separation effect. For example, a filter is mounted in the airflow adjustment valve 24, and the filter is configured to purify high-pressure air in the air pipe 22, thereby avoiding damage caused to the bonded wafer by impurities carried in the high-pressure air.

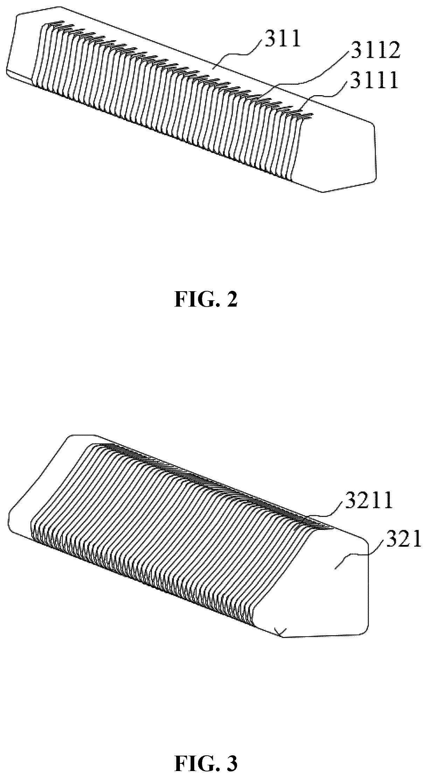

In an embodiment, as shown in FIGS. 1 and 2, the first fixture 31 includes two clamping comb frames 311 symmetrical about each other, the two clamping comb frames 311 are movable towards or away from each other, each clamping comb frame 311 is provided with avoidance slots 3111 and clamping slots 3112 arranged at intervals, and when the two clamping comb frames 311 move towards each other, a clamping slot 3112 is configured to clamp the donor wafer, and an avoidance slot 3111 is configured to avoid the SOI wafer. The clamping comb frame 311 is provided with the avoidance slots 3111 and the clamping slots 3112 so that in a clamping process of the first fixture 31, the donor wafer can be selectively clamped in the case where the SOI wafer is avoided. Thus, not only can the separated donor wafer and SOI wafer be screened, but also mechanical damage caused by clamping to the SOI wafer can be reduced and prevented from affecting a product yield.

In an embodiment, as shown in FIGS. 1 and 3, the second fixture 32 includes two lifting comb frames 321 symmetrical about each other, the two lifting comb frames 321 are movable towards or away from each other, each lifting comb frame 321 is provided with lifting slots 3211, and when the two lifting comb frames 321 move towards each other, a lifting slot 3211 is configured to lift the donor wafer or the SOI wafer. When the separated donor wafer and SOI wafer are transferred from the carrier assembly, the second fixture 32 needs to be manipulated to lift the donor wafer and the SOI wafer. Compared with the mechanical clamping of the SOI wafer, the lifting can reduce the mechanical damage to the SOI wafer and improve the product yield.

In this embodiment, the wafer splitting system includes a first cartridge 4, the first cartridge 4 is configured to store the SOI wafer, and the first fixture 31 and the second fixture 32 is capable of moving the SOI wafer and the donor wafer over the first cartridge 4. After the donor wafer and the SOI wafer are separated, the drive assembly drives the first fixture 31 to clamp the donor wafer, the drive assembly drives the second fixture 32 to simultaneously lift the donor wafer and the SOI wafer, and the second fixture 32 lifts and moves the donor wafer and the SOI wafer over the first cartridge 4. The drive assembly controls the first cartridge 4 to move upward and approach the SOI wafer, and the second fixture 32 releases the donor wafer and the SOI wafer so that the SOI wafer falls into the first cartridge 4 with the donor wafer clamped by the first fixture 31. The SOI wafer is transferred from the carrier assembly 1 into the first cartridge 4 without being mechanically clamped, and the donor wafer mixed therewith is screened so that damage to the SOI wafer is relatively small and the working efficiency is relatively high.

In an embodiment, the wafer splitting system in this embodiment further includes a second cartridge 5, the second cartridge 5 is configured to store the donor wafer, and the first fixture 31 is capable of moving the donor wafer over the second cartridge 5. When the drive assembly drives the first fixture 31 to clamp the donor wafer and the second fixture 32 is in a non-clamping state, the first fixture 31 clamps and moves the donor wafer over the second cartridge 5, the drive assembly controls the second cartridge 5 to move upward and approach the donor wafer, and the first fixture 31 releases the donor wafer so that the donor wafer falls into the second cartridge 5. Thus, the subsequent recycling of the donor wafer is facilitated, and the production cost is reduced.

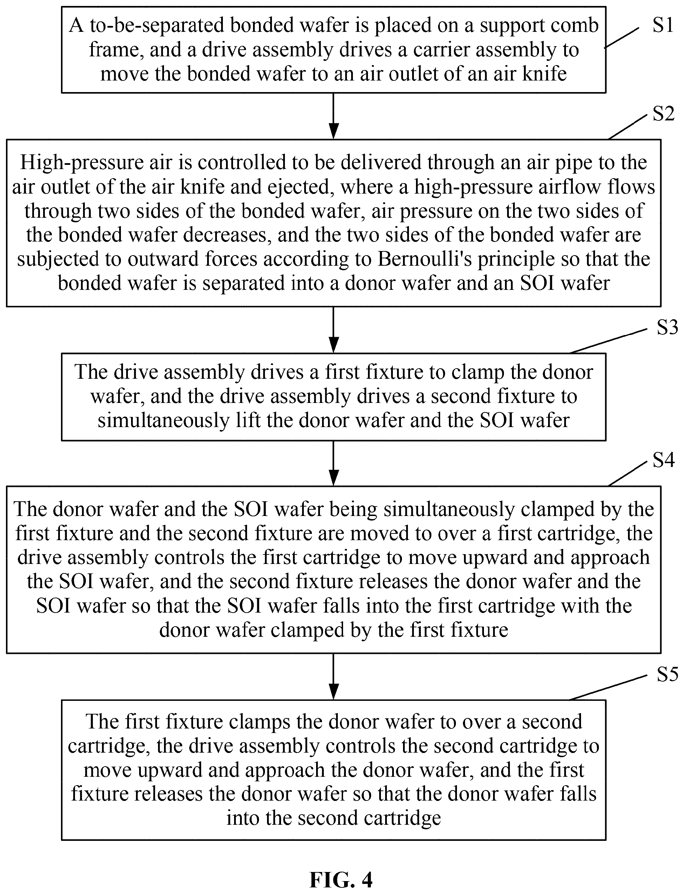

As shown in FIG. 4, this embodiment provides a wafer splitting method applied to the preceding wafer splitting system, and the wafer splitting method includes S1 and S2.

In S1, the to-be-separated bonded wafer is placed on the support comb frame 11, and the drive assembly drives the carrier assembly 1 to move the bonded wafer to the air outlet of the air knife 21.

In S2, the high-pressure air is controlled to be delivered through the air pipe 22 to the air outlet of the air knife 21 and to be ejected, where the high-pressure airflow flows through the two sides of the bonded wafer, the air pressure on the two sides of the bonded wafer decreases, and the two sides of the bonded wafer are subjected to outward forces according to Bernoulli's principle so that the bonded wafer is separated into the donor wafer and the SOI wafer.

According to Bernoulli's principle, the high-speed airflow is ejected from the air knife 21 to the outer sides of the bonded wafer, the pressure on the two sides of the bonded wafer decreases, and the donor wafer and the SOI wafer are separated from each other under the action of atmospheric pressure, thereby avoiding damage caused by the mechanical clamping to the product. Multiple bonded wafers can be simultaneously separated, thereby improving the operation efficiency.

For example, the wafer splitting system includes the first cartridge 4, and the wafer splitting method further includes S3 and S4.

In S3, the drive assembly drives the first fixture 31 to clamp the donor wafer, and the drive assembly drives the second fixture 32 to simultaneously lift the donor wafer and the SOI wafer.

In S4, the donor wafer and the SOI wafer being simultaneously clamped by the first fixture 31 and the second fixture 32 are moved over the first cartridge 4, the drive assembly controls the first cartridge 4 to move upward and approach the SOI wafer, and the second fixture 32 releases the donor wafer and the SOI wafer so that the SOI wafer falls into the first cartridge 4 with the donor wafer clamped by the first fixture 31.

The SOI wafer is transferred from the carrier assembly 1 into the first cartridge 4 without being mechanically clamped, and the donor wafer mixed therewith is screened so that damage to the SOI wafer is relatively small and the working efficiency is relatively high.

In an embodiment, in addition to the first cartridge 4, the wafer splitting system includes the second cartridge 5, and the wafer splitting method further includes S5.

In S5, the first fixture 31 clamps the donor wafer over the second cartridge 5, the drive assembly controls the second cartridge 5 to move upward and approach the donor wafer, and the first fixture 31 releases the donor wafer so that the donor wafer falls into the second cartridge 5.

The first fixture 31 is manipulated to convey the donor wafer into the second cartridge 5 so that the subsequent recycling of the donor wafer is facilitated, and the production cost is reduced.

### Embodiment two

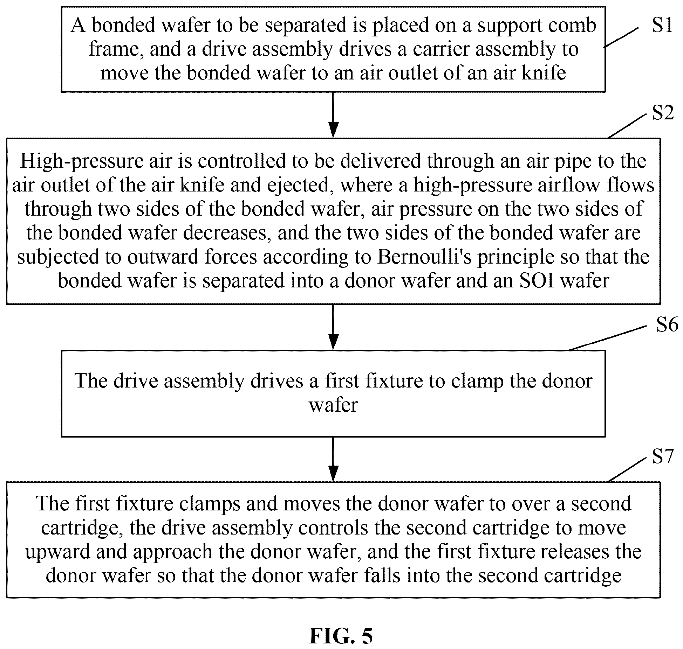

Compared with the wafer splitting system in embodiment one, the wafer splitting system in this embodiment includes only the second cartridge 5 and does not include the first cartridge 4, and the other structures are exactly the same as those in embodiment one. As shown in FIG. 5, after steps S1 and S2, the wafer splitting method in embodiment two further includes S6 and S7.

In S6, the drive assembly drives the first fixture 31 to clamp the donor wafer.

In S7, the first fixture 31 clamps and moves the donor wafer over the second cartridge 5, the drive assembly controls the second cartridge 5 to move upward and approach the donor wafer, and the first fixture 31 releases the donor wafer so that the donor wafer falls into the second cartridge 5.

Without contact with the SOI wafer, the donor wafer mixed therewith is screened, and the SOI wafer is left in the carrier assembly 1, thereby avoiding damage to the SOI wafer and ensuring a yield of separation.

The wafer splitting method provided by the present application is applied to the preceding wafer splitting system. The bonded wafer to be separated is placed on the support comb frame, the drive assembly drives the carrier assembly to move the bonded wafer to the air outlet of the air knife, the high-pressure air is controlled to be delivered through the air pipe to the air outlet of the air knife and ejected, the high-pressure airflow flows through the two sides of the bonded wafer, the air pressure on the two sides of the bonded wafer decreases, and the two sides of the bonded wafer are subjected to the outward forces according to Bernoulli's principle so that the bonded wafer is separated into the donor wafer and the SOI wafer, the drive assembly drives the first fixture to clamp the donor wafer, and the drive assembly drives the second fixture to simultaneously clamp the donor wafer and the SOI wafer. The wafer splitting method can avoid the mechanical damage caused to the product when a mechanical structure separates the bonded wafer. The first fixture and the second fixture are disposed to selectively clamp, transfer, or release the donor wafer and SOI wafer, thereby improving the operation efficiency.

## Claims

1. A wafer splitting system being configured to separate a bonded wafer and comprising:
a mounting frame;
a carrier assembly (1) comprising a support comb frame (11), wherein the support comb frame (11) is provided with a plurality of parallel slots which are vertically arranged, a slot of the plurality of parallel slots is configured to store the bonded wafer to be separated, and the carrier assembly (1) is mounted to the mounting frame;
a separation assembly (2) comprising an air knife (21) and an air pipe (22), wherein one end of the air pipe (22) is connected to the air knife (21), another end of the air pipe (22) is connected to an air source, the air knife (21) is configured to separate the bonded wafer, and the bonded wafer is separable into a donor wafer and a silicon on insulator (SOI) wafer;
a clamping assembly (3) comprising a first fixture (31) and a second fixture (32), wherein the first fixture (31) is configured to clamp or release the donor wafer, and the second fixture (32) is configured to clamp or release the donor wafer and the SOI wafer; and
a drive assembly mounted to the mounting frame, where the drive assembly is configured to drive the clamping assembly (3) to clamp or release the donor wafer and the SOI wafer, and the drive assembly is further configured to drive the carrier assembly (1) to move the bonded wafer to an air outlet of the air knife (21).

2. The wafer splitting system according to claim 1, wherein the first fixture (31) comprises two clamping comb frames (311) symmetrical about each other, the two clamping comb frames (311) are movable towards or away from each other, each of the two clamping comb frames (311) is provided with a plurality of avoidance slots (3111) and a plurality of clamping slots (3112) arranged at intervals, and when the two clamping comb frames (311) move towards each other, a clamping slot (3112) of the plurality of clamping slots (3112) is configured to clamp the donor wafer, and an avoidance slot (3111) of the plurality of avoidance slots (3111) is configured to avoid the SOI wafer.

3. The wafer splitting system according to claim 1, wherein the second fixture (32) comprises two lifting comb frames (321) symmetrical about each other, the two lifting comb frames (321) are movable towards or away from each other, each of the two lifting comb frames (321) is provided with a plurality of lifting slots (3211), and when the two lifting comb frames (321) move towards each other, a lifting slot (3211) of the plurality of lifting slots (3211) is configured to lift the donor wafer or the SOI wafer.

4. The wafer splitting system according to claim 1, further comprising a first cartridge (4), wherein the first cartridge (4) is configured to store the SOI wafer, and the first fixture (31) and the second fixture (32) are configured to move the SOI wafer over the first cartridge (4).

5. The wafer splitting system according to claim 1, further comprising a second cartridge (5), wherein the second cartridge (5) is configured to store the donor wafer, and the first fixture (31) is configured to move the donor wafer over the second cartridge (5).

6. The wafer splitting system according to claim 1, wherein the separation assembly (2) further comprises a switch valve (23) and an airflow adjustment valve (24), wherein the switch valve (23) is configured to control the air source to be connected or disconnected, and the airflow adjustment valve (24) is configured to adjust a magnitude of airflow in the air pipe (22).

7. A wafer splitting method, the method being applied to the wafer splitting system according to any one of claims 1 to 6 and comprising:
placing (S1) a to-be-separated bonded wafer on a support comb frame (11), and driving, by a drive assembly, a carrier assembly (1) to move the bonded wafer to an air outlet of an air knife (21); and
controlling (S2) high-pressure air to be delivered through an air pipe (22) to the air outlet of the air knife (21) and to be ejected, wherein a high-pressure airflow flows through two sides of the bonded wafer, air pressure on the two sides of the bonded wafer decreases, and the two sides of the bonded wafer are subjected to outward forces according to Bernoulli's principle so that the bonded wafer is separated into a donor wafer and a silicon on insulator (SOI) wafer.

8. The wafer splitting method according to claim 7, wherein the wafer splitting system comprises a first cartridge (4), and the wafer splitting method further comprises:
driving (S3), by the drive assembly, a first fixture (31) to clamp the donor wafer, and driving, by the drive assembly, a second fixture (32) to simultaneously lift the donor wafer and the SOI wafer; and
moving (S4) the donor wafer and the SOI wafer being simultaneously clamped by the first fixture (31) and the second fixture (32) over the first cartridge (4), controlling, by the drive assembly, the first cartridge (4) to move upward and approach the SOI wafer, and releasing, by the second fixture (32), the donor wafer and the SOI wafer so that the SOI wafer falls into the first cartridge (4) with the donor wafer clamped by the first fixture (31).

9. The wafer splitting method according to claim 8, wherein the wafer splitting system further comprises a second cartridge (5), and the wafer splitting method further comprises:
clamping (S5), by the first fixture (31), the donor wafer over the second cartridge (5), controlling, by the drive assembly, the second cartridge (5) to move upward and approach the donor wafer, and releasing, by the first fixture (31), the donor wafer so that the donor wafer falls into the second cartridge (5).

10. The wafer splitting method according to claim 7, wherein the wafer splitting system comprises a second cartridge (5), and the wafer splitting method further comprises:
driving (S6), by the drive assembly, a first fixture (31) to clamp the donor wafer; and
clamping and moving (S7), by the first fixture (31), the donor wafer over the second cartridge (5), controlling, by the drive assembly, the second cartridge (5) to move upward and approach the donor wafer, and releasing, by the first fixture (31), the donor wafer so that the donor wafer falls into the second cartridge (5).
